# EUROPEAN PATENT SPECIFICATION

(11) **EP 3 883 233 B1**
(45) Date of publication and mention of the grant of the patent: **09.08.2023**
(21) Application number: 19890587.9
(22) Date of filing: 22.10.2019
(51) Int. Cl.: G06F 1/16, H04N 23/45, H04N 23/54, H04N 23/55, H04N 23/57, H04M 1/02

(54) **DISPLAY SCREEN ASSEMBLY AND ELECTRONIC DEVICE**
ANZEIGEBILDSCHIRMANORDNUNG UND ELEKTRONISCHE VORRICHTUNG
ENSEMBLE ÉCRAN D'AFFICHAGE ET DISPOSITIF ÉLECTRONIQUE

(30) Priority: 29.11.2018 CN 201811444936
(43) Date of publication of application: 22.09.2021
(73) Proprietor: GUANGDONG OPPO MOBILE TELECOMMUNICATIONS CORP., LTD., Dongguan, Guangdong 523860 (CN)
(72) Inventor: YANG, Le, Dongguan, Guangdong 523860 (CN)
(74) Representative: Thorniley, Peter
(86) International application number: PCT/CN2019/112584
(87) International publication number: WO 2020/108174

(56) References cited:
- WO-A1-2017/214582
- CN-A- 107 229 148
- US-A1- 2017 186 820

## Description

### TECHNICAL FIELD

The present disclosure relates to the field of electronic technologies, and more particularly, to a display screen assembly and an electronic device.

### BACKGROUND

Full-screen electronic devices are becoming increasingly popular. However, components such as camera modules occupy much space on electronic devices. A technical problem to be solved is to improve an integration level of components in an electronic device. Patent application publication CN107229148A discloses a display screen, a display device and a mobile terminal. The display screen includes a display part. The display part includes a color filter layer facing a user, a liquid crystal layer which is laminated on one side of the color filter layer and departing from the user, and a thin film transistor layer which is laminated on the liquid crystal layer and departs from the color filter layer. The color filter layer is provided with a through hole, the thin film transistor layer is provided with a mounting zone facing the through hole, and the mounting zone is used for mounting a camera module. Patent application publication WO2017/214582A1 discloses a bio-sensor device, integrated with a display portion, includes a surface for touching by a body part, such as a finger. Patent application publication US2017/0186820A1 discloses an OLED touch display panel capable of detecting and reacting to touches on the display includes a signal sending element emitting ultrasonic signals, a driving layer configured to provide display driving signals, a light-emitting element configured to receive the display driving signals and emit light, and a signal receiving element configured for receiving reflected ultrasonic signal.

### SUMMARY

The present disclosure provides a display screen assembly and an electronic device that are capable of improving an integration level of components.

The present disclosure provides a display screen assembly. The display screen assembly includes a first display laminate and a first display laminate that are opposite to each other. A plurality of image sensors is provided on the first display laminate. A camera lens is provided on the second display laminate. The plurality of image sensors directly faces the camera lens, such that the plurality of image sensors can acquire image signals through the camera lens. The second display laminate further includes a plurality of color filters adjacent to the camera lens, a first light shielding block and a plurality of second light shielding blocks that are space apart from each other. The plurality of color filters corresponds to a plurality of sub-pixel regions in one-to-one correspondence. Each of the plurality of second light shielding blocks is located between two adjacent color filters of the plurality of color filters, and the first light shielding block and the plurality of second light shielding blocks are configured to shield visible light. The first light shielding block includes an extension portion in a cylindrical shape. The extension portion extends from the second display laminate to the first display laminate. One end of the extension portion surrounds the peripheral side of the camera lens, and the other end of the extension portion surrounds a peripheral side of the plurality of image sensors.

Further advantageous embodiments are set out in the dependent claims.

In another aspect, the present disclosure further provides an electronic device. The electronic device includes said display screen assembly.

By arranging the camera lens and the image sensors on the first display laminate and the second display laminate of the display screen assembly, respectively, components having photographing function are integrated in the display screen assembly for display in an electronic device. In this manner, an area occupied by a camera module in a non-display portion of the display screen is reduced, and an integration level of components in the electronic device is improved.

### BRIEF DESCRIPTION OF DRAWINGS

In order to clearly explain technical solutions of embodiments of the present disclosure, drawings used in the embodiments are briefly described below. Obviously, the drawings as described below are merely some embodiments of the present disclosure. Based on these drawings, other drawings can be obtained by those skilled in the art without creative effort.
FIG. 1 is a schematic structural diagram of an electronic device according to an embodiment of the present disclosure.
FIG. 2 is a cross-sectional view of a first type of display screen assembly in an electronic device according to an embodiment of the present disclosure.
FIG. 3 is a top view of a first display laminate in FIG. 2.
FIG. 4 is a cross-sectional view of a second type of display screen assembly in an electronic device according to an embodiment of the present disclosure.
FIG. 5 is another cross-sectional view of a first type of display screen assembly in an electronic device according to an embodiment of the present disclosure.
FIG. 6 is a cross-sectional view of a third type of display screen assembly in an electronic device according to an embodiment of the present disclosure.
FIG. 7 is a cross-sectional view of a fourth type of display screen assembly in an electronic device according to an embodiment of the present disclosure.
FIG. 8 is a cross-sectional view of a fifth type of display screen assembly in an electronic device according to an embodiment of the present disclosure.
FIG. 9 is a cross-sectional view of a sixth type of display screen assembly in an electronic device according to an embodiment of the present disclosure.
FIG. 10 is a cross-sectional view of a seventh type of display screen assembly in an electronic device according to an embodiment of the present disclosure.
FIG. 11 is a cross-sectional view of an eighth type of display screen assembly in an electronic device according to an embodiment of the present disclosure.
FIG. 12 is a cross-sectional view of a receiver and a thin film transistor in a display screen assembly according to an embodiment of the present disclosure.
FIG. 13 is a cross-sectional view of a ninth type of display screen assembly in an electronic device according to an embodiment of the present disclosure.
FIG. 14 is a cross-sectional view of a tenth type of display screen assembly in an electronic device according to an embodiment of the present disclosure.
FIG. 15 is a cross-sectional view of an eleventh type of display screen assembly in an electronic device according to an embodiment of the present disclosure.
FIG. 16 is a top view of thin film transistors and receivers in sub-pixel regions in a display screen assembly according to an embodiment of the present disclosure.
FIG. 17 is a cross-sectional view of a twelfth type of display screen assembly in an electronic device according to an embodiment of the present disclosure.
FIG. 18 is a cross-sectional view of a thirteenth type of display screen assembly in an electronic device according to an embodiment of the present disclosure.
FIG. 19 is a cross-sectional view of a fourteenth type of display screen assembly in an electronic device according to an embodiment of the present disclosure.
FIG. 20 is a top view of a fifteenth type of display screen assembly in an electronic device according to an embodiment of the present disclosure.
FIG. 21 is a top view of a sixteenth type of display screen assembly in an electronic device according to an embodiment of the present disclosure.
FIG. 22 is a top view of a seventeenth type of display screen assembly in an electronic device according to an embodiment of the present disclosure.

### DESCRIPTION OF EMBODIMENTS

Technical solutions of embodiments of the present disclosure are clearly and fully described below in combination with drawings of the embodiments of the present disclosure.

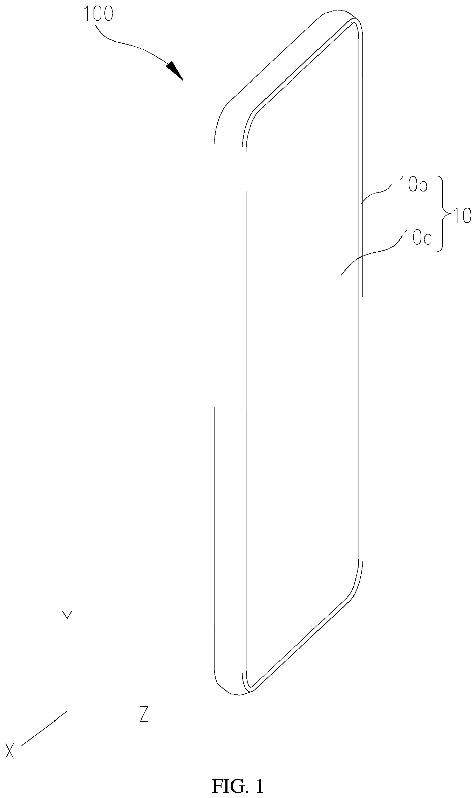

FIG. 1 illustrates an electronic device 100 according to a first embodiment of the present disclosure. Referring to FIG. 1, the electronic device 100 includes a display screen assembly 10. It can be understood that the electronic device 100 may be an electronic device having touch and display functions, such as a mobile phone, a notebook, a palmtop computer, an e-reader, a television, a smart home appliance, a smart operation screen, a smart home system, a wearable electronic device, a vehicle display, and the like. For ease of description, the present disclosure defines a length direction of the electronic device 100 as a direction Y, a width direction of the electronic device 100 as a direction X, and a thickness direction of the electronic device 100 as a direction Z.

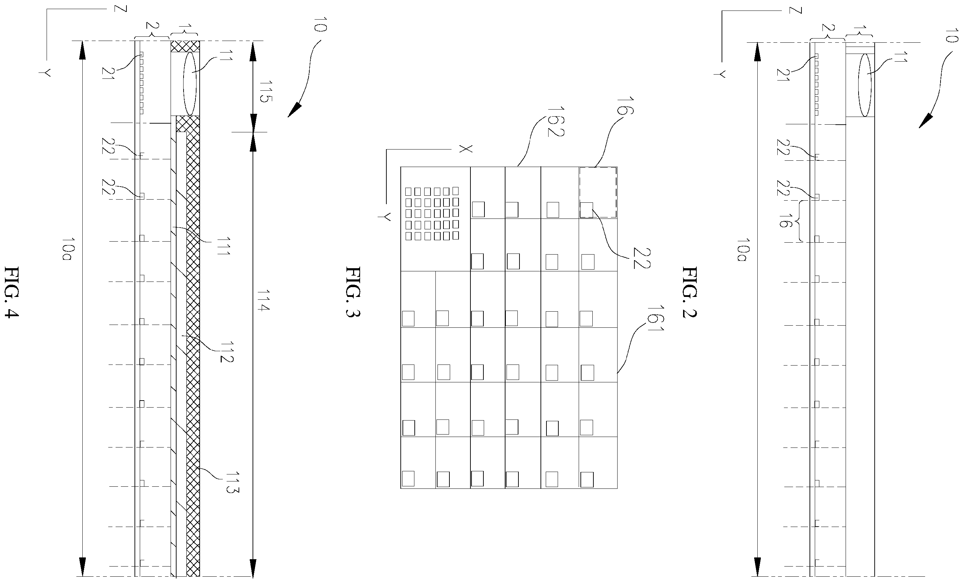

FIG. 2 illustrates a display screen assembly 10 according to an embodiment of the present disclosure. Referring to FIG. 2, the display screen assembly 10 includes a first display laminate 2 and a second display laminate 1 that are opposite to each other. A plurality of image sensors 21 is arranged on the first display laminate 2. A camera lens 11 is arranged on the second display laminate 1. The plurality of image sensors 21 directly faces the camera lens 11, and thus, the plurality of image sensors 21 can acquire image signals through the camera lens 11. Specifically, an orthographic projection of the camera lens 11 on the first display laminate 2 may completely or partially cover the plurality of image sensors 21. It can be understood that the image sensors 21 and the camera lens 11 may form a camera module, i.e., a camera module configured to perform a photographing function.

By arranging the camera lens 11 on the second display laminate 1 of the display screen assembly 10 and the image sensors 21 on the first display laminate 2 of the display screen assembly 10, the components having the photographing function can be integrated in the display screen assembly 10 to reduce an area occupied by the camera module and increase an integration level of the components in the electronic device 100. In addition, installation processes of the camera module and a display screen in the related art may also be reduced, and it is unnecessary to reserve assembly space for the camera module in a middle frame, thereby saving space in the electronic device 100.

Referring to FIG. 1 and FIG. 2, it can be understood that the display screen assembly 10 may include a display portion 10a, and a non-display portion 10b surrounding the display portion 10a. The second display laminate 1 and the first display laminate 2 may form the display portion 10a. The camera lens 11 and the image sensors 21 can be integrated in the display portion 10a of the display screen assembly 10 to reduce an area in the non-display portion 10b of the display screen assembly 10 occupied by the camera module, thereby increasing a screen-to-body ratio of the electronic device 100.

Specifically, referring to FIG. 2 and FIG. 3, the first display laminate 2 may be a thin film transistor laminate. The first display laminate 2 may include a plurality of scanning lines 161 (horizontal grid lines illustrated in FIG. 3 are all scanning lines), a plurality of data lines 162 (vertical grid lines illustrated in FIG. 3 are all data lines), and a plurality of thin film transistors 22. The plurality of scanning lines 161 intersects the plurality of data lines 162 to define a plurality of sub-pixel regions 16 arranged in an array. At least one of the thin film transistors 22 may be arranged in each sub-pixel region 16. The thin film transistor 22 may be electrically connected to the scanning line 161 and the data line 162. Referring to FIG. 2, the plurality of image sensors 21 may be arranged outside the sub-pixel regions 16 and adjacent to the sub-pixel regions 16. In other embodiments, the plurality of image sensors 21 may be arranged in the sub-pixel regions 16. The data line 162 and the scanning line 161 may be electrically connected to the image sensor 21, and thus the data line 162 and the scanning line 161 may transmit signals to the image sensor 21 and the thin film transistor 22. In this way, the data line 162 and the scanning line 161 may be both used for dual purposes, a structure in the display screen assembly 10 may be simplified, and space of the display screen assembly 10 may be saved.

It can be understood that, in a process of molding the image sensors 21 on the first display laminate 2, a process of molding the image sensors 21 may be performed during a process of molding the thin film transistors 22; or the process of molding the image sensors 21 may overlap the process of molding the thin film transistors 22 to simplify processes of molding the image sensors 21 and the thin film transistors 22, thereby saving time and cost.

It can be understood that the display screen assembly 10 may be a liquid crystal display screen or an organic light-emitting diode display screen. When the display screen assembly 10 is a liquid crystal display, the first display laminate 2 may be a thin film transistor laminate, and the second display laminate 1 may be a color filter laminate. When the display screen assembly 10 is an organic light-emitting diode display screen, the first display laminate 2 may be a thin film transistor laminate, and the second display laminate 1 may be an encapsulation layer arranged on the thin film transistor laminate.

In an embodiment, referring to FIG. 4, the display screen assembly 10 is an organic light-emitting diode display screen. The second display laminate 1 may include a substrate 111, an organic light-emitting layer 112 arranged on the substrate 111, and an encapsulation layer 113 covering the organic light-emitting layer 112. The camera lens may be embedded in the encapsulation layer. 113.

Further, referring to FIG. 4, the encapsulation layer 113 has a covering portion 114 and an edge portion 115 surrounding the covering portion 114. The covering portion 114 covers the organic light-emitting layer 112. The edge portion 115 covers a peripheral region of the organic light-emitting layer 112. The camera lens 11 may be embedded in the edge portion 115. The edge portion 115 may cover the first display laminate 2. A distance between the edge portion 115 and the first display laminate 2 is small, and thus a distance between the camera lens 11 and the image sensors 21 is small, allowing the loss of light passing through the camera lens 11 to be small.

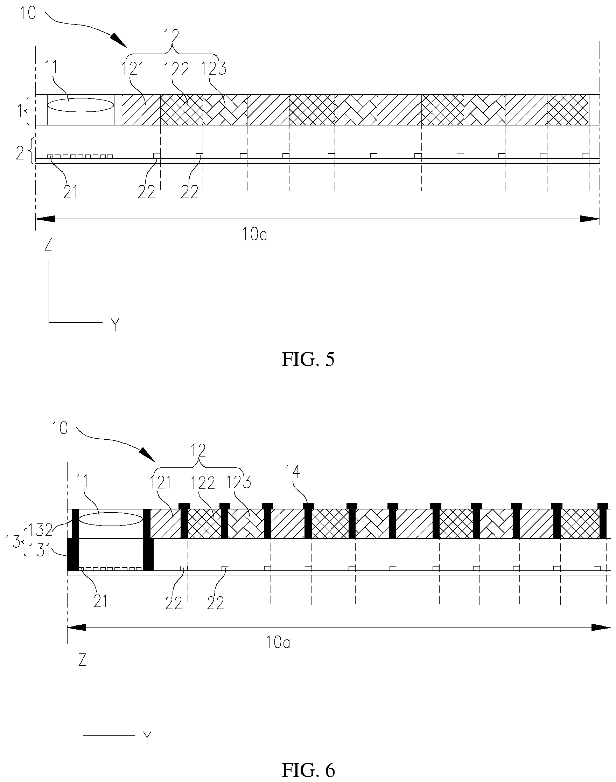

In another embodiment, referring to FIG. 5, the display screen assembly 10 is a liquid crystal display screen. The second display laminate 1 includes a plurality of color filters 12 adjacent to the camera lens 11. The plurality of color filters 12 and the plurality of sub-pixel regions 16 are arranged in one-to-one correspondence.

It can be understood that, referring to FIG. 5, the plurality of color filters 12 may include multiple red color resists 121, multiple green color resists 122, and multiple blue color resists 123. The plurality of color filters 12 may be arranged according to a certain pattern. For example, the plurality of color filters 12 are arranged in a row and column array, which is present as an array of red, green and blue pixels. In other embodiments, the plurality of color filters 12 may also present color of yellow, orange, etc. The plurality of color filters 12 may be the same or different sizes.

In an embodiment, referring to FIG. 5, an area occupied by the camera lens 11 may be an area occupied by the plurality of color filters 12, and this embodiment adopts such a structure as an example for description. In other embodiments, a plurality of camera lenses 11 may be provided. An area occupied by each camera lens 11 may be an area of one color filter 12. The plurality of camera lenses 11 may be arranged in an array. The plurality of image sensors 21 may acquire image signals through the plurality of camera lenses 11 and compose image information frame by frame.

In an embodiment, referring to FIG. 6, the second display laminate 1 further includes a first light shielding block 13 and second light shielding blocks 14. The first light shielding block 13 surrounds the camera lens 11. The second light shielding blocks 14 is located between two adjacent color filters 12. The first light shielding block 13 and the second light shielding block 14 can be both configured to block visible light and prevent visible light from passing through.

Specifically, the first light shielding block 13 and the second light shielding block 14 may be black matrices in the display screen assembly 10. A material of the first light shielding block 13 and the second light shielding block 14 may be resin material or metal oxide that has good light shielding property. The first light shielding block 13 surrounds the camera lens 11 to prevent light emitted from the color filter 12 from interfering with image capture of the camera module. It can be understood that the first light shielding block 13 may define an annular cavity. The annular cavity is adapted to a shape of the camera lens 11. The camera lens 11 may be fixed in the annular cavity. That is, in addition to the shielding light function, the first light shielding block 13 is also configured to serve as a base for fixing the camera lens 11, allowing the camera lens 11 to be firmly assembled on the second display laminate 1. Meanwhile, an additional structure for fixing the camera lens 11 can be omitted, such that the first light shielding block 13 can be used for dual purposes. In addition, the second light shielding block 14 is located between two adjacent color filters 12 to prevent light crosstalk between different color filters 12 from causing image distortion. Specifically, the thin film transistor 22 may directly face the second light shielding block 14, and thus the second light shielding block 14 can cover the thin film transistor 22.

Further, referring to FIG. 6, the first light shielding block 13 includes an extension portion 131 in a cylindrical shape. The extension portion 131 extends from the second display laminate 1 to the first display laminate 2. One end of the extension portion 131 surrounds a peripheral side of the camera lens 11, and the other end of the extension portion 131 surrounds a peripheral side of the plurality image sensors 21 on the first display laminate 2.

Specifically, referring to FIG. 6, the first light shielding block 13 may include a body 132, and the extension portion 131 connecting to the body 132. The body 132 of the first light shielding block 13 surrounds the camera lens 11. The extension portion 131 extends from an end of the body 132 close to the first display laminate 2 to the first display laminate 2. The extension portion 131 has a cylindrical shape. The extension portion 131 surrounds the plurality of image sensors 21. That is, the body 132 and the extension portion 131 are connected to each other to define an enclosing cavity in a cylindrical shape. The camera lens 11 is fixed at one end of the enclosing cavity. The plurality of image sensors 21 is located at the other end of the enclosing cavity. The enclosing cavity can prevent external light from interfering with the image sensors 21, thereby improving imaging quality of the image sensors 21.

It can be understood that the extension portion 131 may be made of a light-shielding material and a material with certain rigidity, such that the extension portion 131 can have a shielding light function and a supporting function between the second display laminate 1 and the first display laminate 2. The extension portion 131 may be supported between the second display laminate 1 and the first display laminate 2 to define a spacing between the second display laminate 1 and the first display laminate 2.

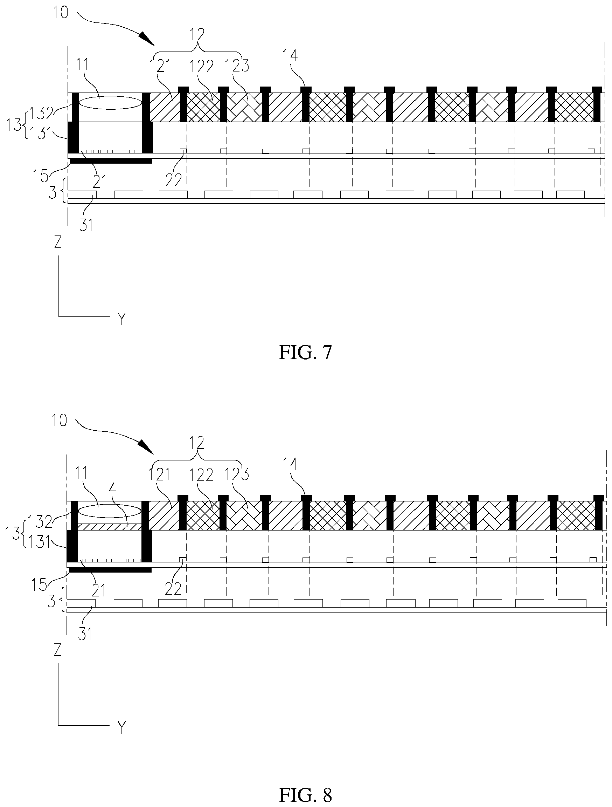

Further, referring to FIG. 7, the display screen assembly 10 may further include a backlight assembly 3. The backlight assembly 3 is located on a side of the first display laminate 2 facing away from the second display laminate 1. The backlight assembly 3 may be configured to emit visible light towards the first display laminate 2, such that the display portion 10a of the display screen assembly 10 can have display brightness. It can be understood that the backlight assembly 3 may be provided with a plurality of light-emitting sources 31. The plurality of light-emitting sources 31 may emit visible light towards the first display laminate 2. A light shielding sheet 15 may be provided on a side of the image sensors 21 close to the backlight assembly 3. The light shielding sheet 15 may be configured to shield the visible light emitted by the backlight assembly 3.

Specifically, referring to FIG. 7, the light shielding sheet 15 may be arranged on the first display laminate 2. The light shielding sheet 15 may be arranged between the image sensors 21 and the backlight assembly 3. The light shielding sheet 15 may be configured to shield the visible light emitted from the backlight assembly 3 towards the image sensors 21 and prevent the light from interfering with the image capture of the image sensors 21.

It can be understood that the light-emitting source 31 on the backlight assembly 3 may be arranged at a position directly facing the thin film transistor 22, and the light-emitting source 31 may not be arranged in a region of the backlight assembly 3 directly facing the image sensor 21. In this way, light emitted by the light-emitting source 31 of the backlight assembly 3 may be directed towards the thin film transistor 22 and the color filter 12 to generate a display image. The light emitted by the light-emitting sources 31 of the backlight assembly 3 cannot be directed towards the image sensors 21, since the light is shielded by the light shielding sheet 15. Thus, the image sensors 21 can be protected from being interfered by the light emitted by the backlight assembly 3.

Further, referring to FIG. 7, an orthographic projection of the first light shielding block 13 on the first display laminate 2 may be located in the light shielding sheet 15.

Specifically, the light shielding sheet 15 may cover an opening of the extension portion 131 close to the first display laminate 2. The light shielding sheet 15 and the first light shielding block 13 may effectively shield light signals on a peripheral side of the image sensors 21 to prevent the image sensors 21 from being interfered by external light and to improve the imaging quality of the image sensor 21.

In an embodiment, referring to FIG. 8, the display screen assembly 10 may further include a light filter 4. The light filter 4 may be located between the camera lens 11 and the plurality of image sensors 21.

Specifically, the light filter 4 may be an infrared light filter 4. The light filter 4 may be configured to transmit visible light of a certain wavelength and reflect infrared light, for improving image capturing quality of the image sensors 21. In other embodiments, the light filter 4 may also filter light of other wavelength bands to improve the imaging quality of the image sensors 21.

Further, referring to FIG. 8, the light filter 4 may be located on the second display laminate 1 and directly face the camera lens 11.

Specifically, the light filter 4 may directly face the camera lens 11 to remove interference light from light entering the camera lens 11. In this way, light received by the image sensor 21 does not include light interfering with image quality, thereby improving the imaging quality of the electronic device. Specifically, the light filter 4 may be fixed in the enclosing cavity defined by the first light shielding block 13.

In other embodiments, the light filter 4 may also be arranged on a side of the second display laminate 1 facing away from the first display laminate 2 and directly face the camera lens 11; or the light filter 4 may also be arranged on the first display laminate 2 and directly face the multiple image sensors 21.

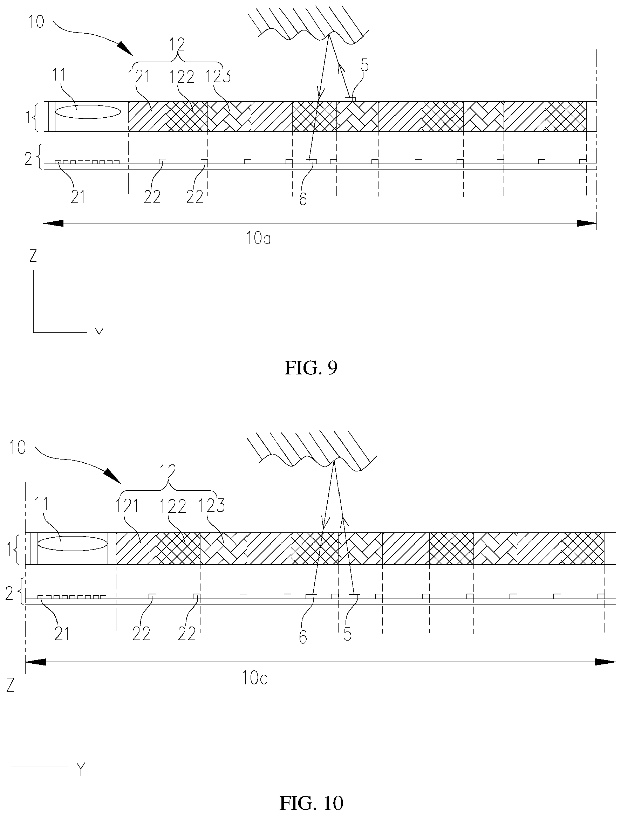

FIG. 9 illustrates a display screen assembly in an electronic device 200 according to a second embodiment of the present disclosure. Referring to FIG. 9, the second embodiment differs from the first embodiment in that, no light filter 4 is provided on the second display laminate 1. That is, interference light such as infrared light is not excluded from the light received by the image sensors 21. In this case, a chip configured to exclude the interference light may be arranged in the camera module. In this way, the interference light can be excluded from the image signal acquired by the image sensors 21 without providing the light filter 4.

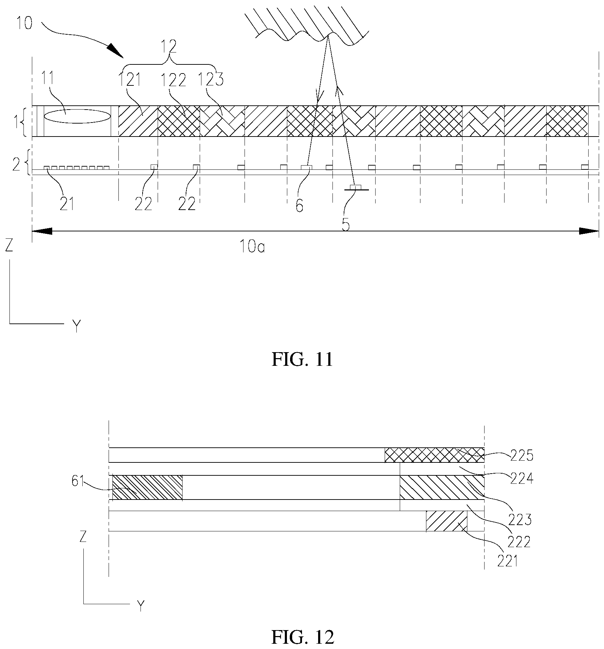

Referring to FIG. 9 to FIG. 11, the display screen assembly 10 may further include a first emitter 5 and a receiver 6. Referring to FIG. 9, the first emitter 5 may be located on the second display laminate 1. Referring to FIG. 10, the first emitter 5 may be located on the first display laminate 2. Referring to FIG. 11, the first emitter 5 may be located in a region outside the second display laminate 1 and the first display laminate 2. For example, the first emitter 5 may be located between the second display laminate 1 and the first display laminate 2, on a side of the second display laminate 1 facing away from the first display laminate 2, on a side of the first display laminate 2 facing away from the second display laminate 1, in the non-display portion 10b of the display screen assembly 10, and the like. In the present embodiment, a position of the first emitter 5 is not limited, as long as an optical signal emitted by the first emitter 5 can be received by the receiver 6. In other embodiments, the first emitter 5 may also be located on a structure in the electronic device other than the display screen assembly 10, for example, located on a housing of the electronic device, located in a gap between the housing and the display screen assembly 10 of the electronic device, and the like.

By arranging the first emitter 5 and the receiver 6 in the display portion 10a of the display screen assembly 10, an area of the non-display portion 10b of the display screen assembly 10 can be further reduced, and the screen-to-body ratio of the display screen assembly 10 can be further increased.

In a possible embodiment, referring to FIG. 9 to FIG. 11, the receiver 6 may be located on the first display laminate 2, and the receiver 6 may be connected to the thin film transistor 22. The receiver 6 may be configured to receive invisible light emitted by the first emitter 5. Specifically, the invisible light may be any one of infrared light, ultraviolet light, or a combination of thereof.

It can be understood that the receiver 6 and the first emitter 5 may be combined to form a proximity sensor configured to detect whether an approaching object is moving towards or away from the display screen, so as to perform operations such as awakening the display portion 10a of the display screen, turning off the screen brightness, or unlocking the screen.

It can be understood that a plurality of receivers 6 and a plurality of transmitters 5 may be provided. The plurality of transmitters 5 and the plurality of receivers 6 can be combined to form a fingerprint recognition module or an iris recognition module. The invisible light emitted by the transmitter 5 may detect biometric information such as fingerprints, palm prints, joint prints, ear prints, iris, etc., so as to perform biometric recognition in the screen and to improve safety performance of the electronic device.

It can be understood that the receiver 6 may also be configured as an ambient light sensor to detect brightness of an environment where the electronic device is located currently, and configured to adjust the display brightness of the display screen assembly 10 based on a detection result.

Specifically, referring to FIG. 12, the receiver 6 may include a photosensitive layer 61, and the photosensitive layer 61 has a special response. For example, the photosensitive layer 61 may change its own resistance value based on an intensity of received invisible light, and a change in an intensity value of the invisible light can be obtained by detecting a change in the resistance value of the photosensitive layer 61. A material of the photosensitive layer 61 may be a semiconductor material such as lead sulfide.

Specifically, referring to FIG. 12, the thin film transistor 22 may include a gate layer 221, a gate insulating layer 222, a source and drain layer 223, a planarization layer 224 and a pixel electrode layer 225 that are stacked sequentially. The photosensitive layer 61 may be arranged on the same layer as the gate layer 221, or the source and drain layer 223, or the pixel electrode layer 225. A patterning of the photosensitive layer 61 may be performed during a molding process of patterning the gate layer 221, the source and drain layer 223, or the pixel electrode layer 225, thereby simplifying a molding process of the photosensitive layer 61 and saving time and manufacturing cost. In addition, the data line 162 and the scanning line 161 may also be electrically connected to the photosensitive layer 61 of the receiver 6 for data transmission between the photosensitive layer 61 and a chip of the receiver 6. That is, the receiver 6 may be connected to the thin film transistor 22 through the data line 162 and the scanning line 161. Consequently, the data line 162 and the scanning line 161 may serve as signal transmission lines for the thin film transistor 22, the image sensor 21, and the receiver 6. In this way, the data line 162 and the scanning line 161 both can be used for multiple purposes, thereby reducing the structures in the display screen assembly 10 and saving the space of the display screen assembly 10.

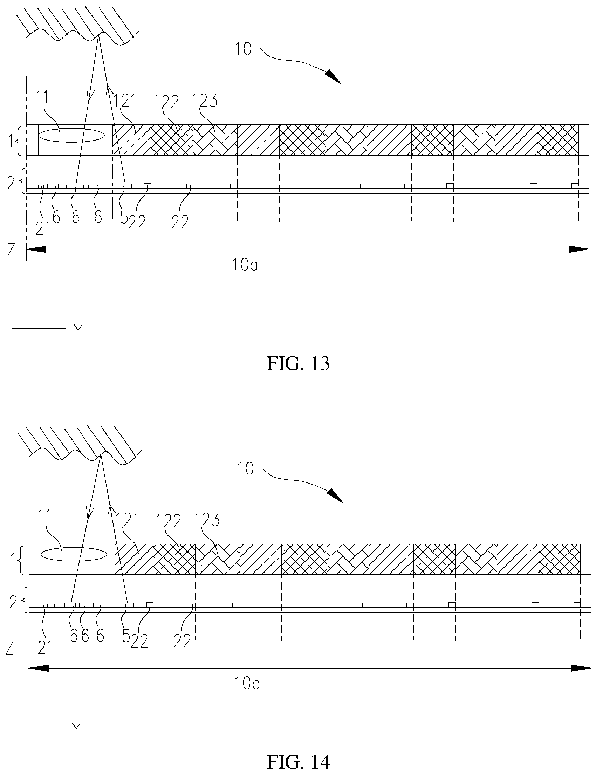

In a possible embodiment, referring to FIG. 13, a plurality of receivers 6 may be provided. The plurality of receivers 6 may directly face a region of the second display laminate 1 where the camera lens 11 is arranged. The camera lens 11 can converge invisible light to the plurality of receivers 6, so as to increase an intensity of the invisible light received by the receiver 6 and fully exert a light-converging function of the camera lens 11 at the same time.

Further, referring to FIG. 13, the plurality of image sensors 21 may be arranged in an array. The receiver 6 may be arranged between two adjacent image sensors 21. That is, the camera lens 11 directly faces a region where the plurality of image sensors 21 is located and a region where the plurality of receivers 6 is located. In this way, the image sensors 21 can acquire all image signals passing through the camera lens 11, and the receivers 6 can receive all invisible light signals passing through the camera lens 11, thereby improving the imaging quality of the image sensors 21 and increasing signal-receiving efficiency of the receiver 6 at the same time.

In other embodiments, referring to FIG. 14, the region where the plurality of image sensors 21 is located may be adjacent to the region where the plurality of receivers 6 is located.

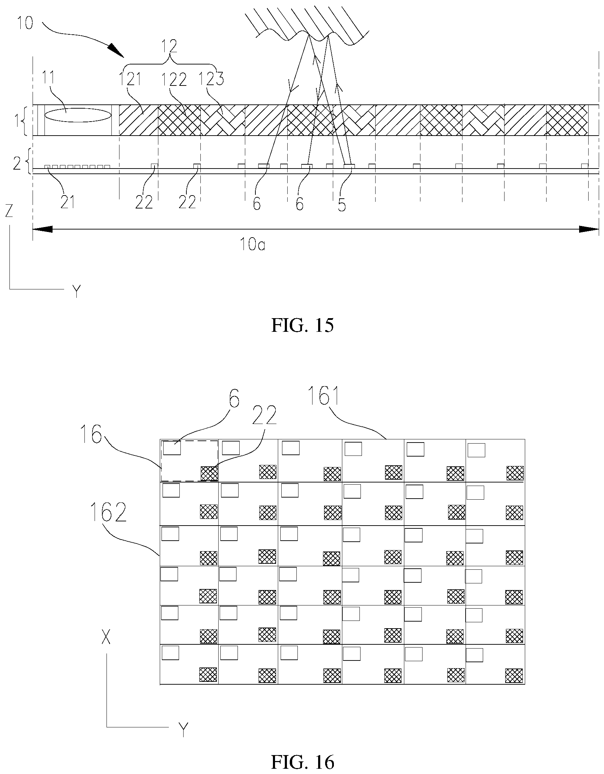

In a possible embodiment, referring to FIG. 15, a plurality of receivers 6 may be provided. Each receiver 6 may be located on the first display laminate 2 in a region directly facing the color filter 12. Each receiver 6 may be located between two adjacent thin film transistors 22.

Specifically, referring to FIG. 15 and FIG. 16, a plurality of receivers 6 may be provided. One or more receivers 6 may be located in one sub-pixel region 16. In each sub-pixel region 16, one thin film transistor 22 and at least one receiver 6 are provided. The receiver 6 and the thin film transistor 22 located in the same sub-pixel region 16 may be adjacent to each other or in diagonal, so as to reduce mutual interference between the receiver 6 and the thin film transistor 22 and to increase an aperture ratio of the sub-pixel region 16. In addition, the receiver 6 may also be located outside the sub-pixel region 16, for example, located between two adjacent sub-pixel regions 16.

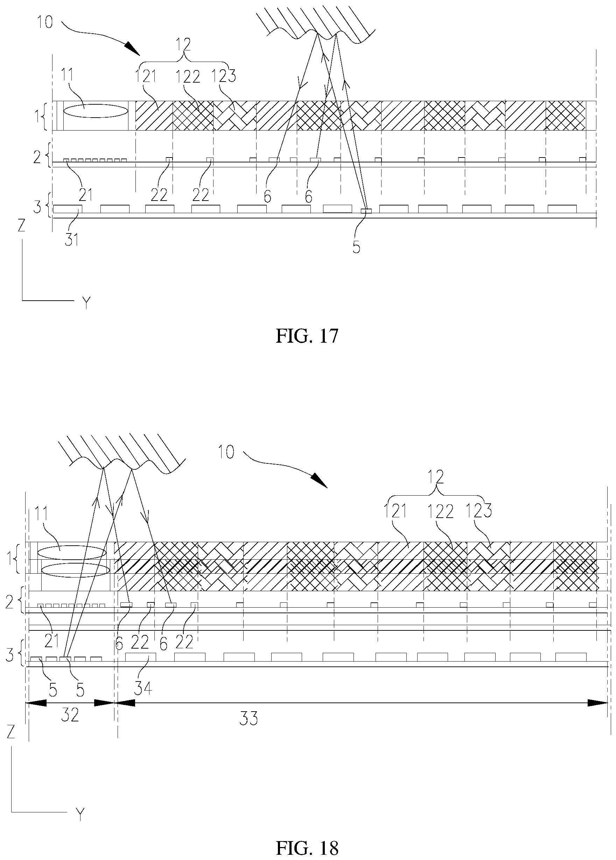

Referring to FIG. 17, the display screen assembly 10 may further include a backlight assembly 3. The backlight assembly 3 may face the side of the first display laminate 2 facing away from the second display laminate 1. The backlight assembly 3 may be configured to emit visible light towards the first display laminate 2. The first emitter 5 may be located on the backlight assembly 3. The first emitter 5 may be configured to emit invisible light towards the first display laminate 2.

Specifically, the first emitter 5 may be a light-emitting diode (LED) lamp, a mini-LED lamp, or a micro-LED lamp. The first emitter 5 may be arranged on the backlight assembly 3. The first emitter 5 and the light-emitting sources 31 on the backlight assembly 3 may share a driving circuit and a controller, without additionally providing a driving circuit and a controller for the first emitter 5. In this way, the space on the backlight assembly 3 can be saved, and a utilization rate of the original structure can be improved.

In a possible embodiment, referring to FIG. 18, the backlight assembly 3 may have a first backlight portion 32 and a second backlight portion 33 that are connected to each other. The first backlight portion 32 may directly face the region where the plurality of image sensors 21 is located. The second backlight portion 33 may directly face the region where the plurality thin film transistors 22 is located. A plurality of first emitters 5 is provided. The first emitters 5 may be located in the first backlight portion 32.

Specifically, the first emitters 5 may directly face the plurality of image sensors 21. The invisible light emitted by the first emitters 5 may be emitted through the plurality of image sensors 21 and the camera lens 11, and then reflected and projected onto the receivers 6 arranged on the first display laminate 2. The receiver 6 may be arranged on the first display laminate 2 in a region where the thin film transistor 22 are arranged, and the receiver 6 may be configured to capture fingerprint or detect distance. In other embodiments, the receiver 6 may also be located on the first display laminate 2 in a region where the image sensors 21 are arranged.

Further, referring to FIG. 18, the backlight assembly 3 may further include a plurality of second emitters 34. The plurality of second emitters 34 is configured to emit visible light towards the second display laminate 1. The plurality of second emitters 34 may be located in the second backlight portion 33. Since the visible light sources of the backlight assembly 3 directly face the thin film transistors 22 and offset from a region where the image sensors 21 and the camera lens are located, the interference of the visible light sources on image signal acquisition of the image sensor 21 may be reduced. Meanwhile, the first emitter 5 emitting invisible light is provided in a region of the backlight assembly 3 directly facing the image sensors 21 to utilize the space on the backlight assembly 3 reasonably. In addition, the invisible light emitted by the first emitter 5 does not interfere with image information acquired by the image sensor 21, thereby improving the quality of image capture.

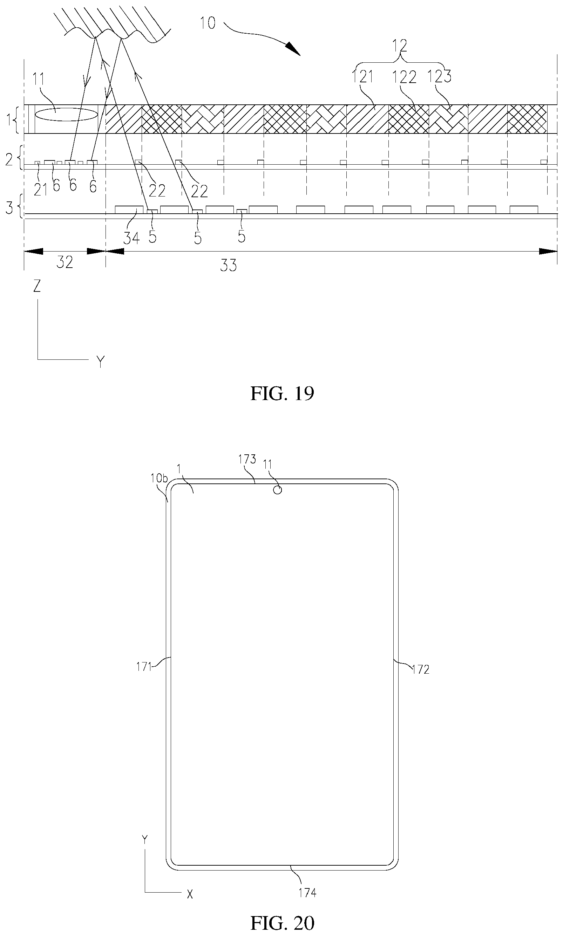

In another possible embodiment, referring to FIG. 19, the backlight assembly 3 may have a first backlight portion 32 and a second backlight portion 33 that are connected to each other. The first backlight portion 32 may directly face the region where the plurality of image sensors 21 is located. The second backlight portion 33 may directly face the region where the plurality of thin film transistors 22 is located. The first emitter 5 may be located at a position on the second backlight portion 33 close to the first backlight portion 32. That is, the first emitter 5 may be located on the backlight assembly 3 in the region directly facing the thin film transistors 22. In this case, the receiver 6 may be located on the first display laminate 2 in the region where the plurality of image sensors 21 is arranged or located on the first display laminate 2 in the region where the thin film transistors 22 are arranged. Alternatively, the receiver 6 may also be located on the backlight assembly 3 in the region directly facing the plurality of image sensors 21.

Further, referring to FIG. 19, the backlight assembly 3 may further include a plurality of second emitters 34 arranged in an array. The plurality of second emitters 34 may be configured to emit the visible light towards the second display laminate 1. The plurality of second emitters 34 may be located on the second backlight portion 33. A plurality of first emitters 5 is provided. The first emitter 5 may be arranged between two adjacent second emitters 34. That is, the first emitters 5 and the second emitters 34 are located in a region directly facing the thin film transistors 22.

Specifically, the first emitter 5 may be located between two adjacent second emitters 34. When a plurality of first emitters 5 is provided, the plurality of first emitters 5 may be distributed over the entire second backlight portion 33, that is, the entire display portion 10a of the display screen assembly 10 can perform fingerprint detection, or proximity detection, or ambient light detection, and the like.

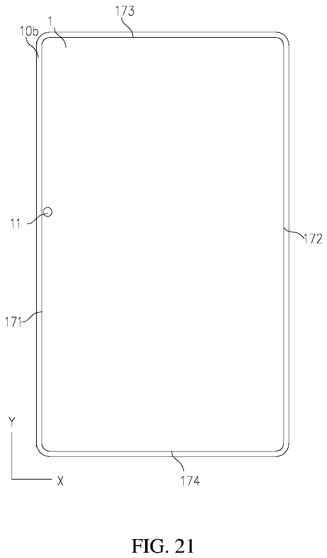

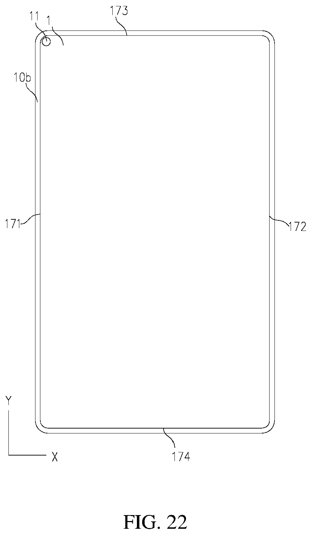

In combination with any of the above embodiments, referring to FIG. 20 to FIG. 21, the second display laminate 1 may include two opposite long sides 171, 172 and two opposite short sides 173, 174. The two long sides 171, 172 may be connected between the two short sides 173, 174. Referring to FIG. 20, the camera lens 11 is close to one short side 173; or referring to FIG. 21, the camera lens 11 is close to one long side 171; or referring to FIG. 22, the camera lens 11 is close to a position where one long side 171 and one short side 173 are connected to each other.

By arranging the camera module at an edge or a corner region of the display portion 10a, a region for a photographing function and a region for a display function of the electronic device can be separated, and thus the photographing function and the display function will not interfere with each other, thereby improving user experience of the electronic device.

The above are some embodiments of the present disclosure. It should be pointed out that those skilled in the art can make several improvements and modifications without departing from principles of the present disclosure and the scope of the present disclosure is as defined by the appended claims.

## Claims

1. A display screen assembly (10), comprising:
a first display laminate (2) and a second display laminate (1) that are opposite to each other;
a plurality of image sensors (21) arranged on the first display laminate (2); and
a camera lens (11) arranged on the second display laminate (1),
wherein the plurality of image sensors (21) directly faces the camera lens (11), and the plurality of image sensors (21) is configured to acquire image signals through the camera lens (11),
**characterized in that**,
the second display laminate (1) comprises a plurality of color filters (12) adjacent to the camera lens (11), a first light shielding block (13) and a plurality of second light shielding blocks (14) that are space apart from each other; the plurality of color filters (12) corresponds to a plurality of sub-pixel regions (16) in one-to-one correspondence; each of the plurality of second light shielding blocks (14) is located between two adjacent color filters (12) of the plurality of color filters (12), and the first light shielding block (13) and the plurality of second light shielding blocks (14) are configured to shield visible light,
the first light shielding block (13) comprises an extension portion (131) in a cylindrical shape, the extension portion (131) extends from the second display laminate (1) to the first display laminate (2), one end of the extension portion (131) surrounds the peripheral side of the camera lens (11), and the other end of the extension portion (131) surrounds a peripheral side of the plurality of image sensors (21).

2. The display screen assembly (10) according to claim 1, wherein the first display laminate (2) comprises a plurality of scanning lines (161), a plurality of data lines (162), and a plurality of thin film transistors (22);
the plurality of scanning lines (161) intersects the plurality of data lines (162) to define the plurality of sub-pixel regions (16) arranged in an array;
at least one of the plurality of thin film transistors (22) is arranged in one of the plurality of sub-pixel regions (16); and
the plurality of image sensors (21) is located outside the plurality of sub-pixel regions (16) and adjacent to the plurality of sub-pixel regions (16), or the plurality of image sensors (21) is arranged in the plurality of sub-pixel regions (16).

3. The display screen assembly (10) according to claim 1, wherein the second display laminate (1) further comprises a substrate (111), an organic light-emitting layer (112) arranged on the substrate (111), and an encapsulation layer (113) covering the organic light-emitting layer (112), the camera lens (11) being embedded in the encapsulation layer (113).

4. The display screen assembly (10) according to claim 3, wherein the encapsulation layer (113) comprises a covering portion (114), and an edge portion (115) surrounding the covering portion (114), the covering portion (114) is configured to cover the organic light-emitting layer (112), the edge portion (115) is configured to cover a peripheral region of the organic light-emitting layer (112), and the camera lens (11) is embedded in the edge portion (115).

5. The display screen assembly (10) according to any one of claims 1 to 4, further comprising a first emitter (5) and a receiver (6),
wherein the receiver (6) is located on the first display laminate (2), and the receiver (6) is configured to receive invisible light emitted by the first emitter (5) and reflected by an object to be detected, or the receiver (6) is configured to detect brightness of ambient light, and
wherein the first emitter (5) is located on the second display laminate (1); or the first emitter (5) is located on the first display laminate (2); or the first emitter (5) is located in a region outside the second display laminate (1) and the first display laminate (2).

6. The display screen assembly (10) according to claim 5, wherein a plurality of receivers (6) is provided, and the plurality of receivers (6) directly faces a region of the second display laminate (1) where the camera lens (11) is arranged, and
wherein the plurality of image sensors (21) is arranged in an array, and each of the plurality of receivers (6) is arranged between two adjacent image sensors (21) of the plurality of image sensors (21).

7. The display screen assembly (10) according to claim 5, wherein a plurality of receivers (6) is provided, one or more receivers of the plurality of receivers (6) are located in one sub-pixel region of the plurality of sub-pixel regions (16), and the one or more receivers (6) and the at least one of the plurality of thin film transistors (22) located in the one sub-pixel region (16) are adjacent to each other or arranged in a diagonal.

8. The display screen assembly (10) according to claim 7, further comprising a backlight assembly (3), wherein the backlight assembly (3) faces a side of the first display laminate (2) facing away from the second display laminate (1), the first emitter (5) is located on the backlight assembly (3), and the first emitter (5) is configured to emit the invisible light towards the first display laminate (2).

9. The display screen assembly (10) according to claim 8, wherein the backlight assembly (3) comprises a first backlight portion (32) and a second backlight portion (33) that are connected to each other, the first backlight portion (32) directly faces a region where the plurality of image sensors (21) is located, the second backlight portion (33) directly faces a region where the plurality of thin film transistors (22) is located, a plurality of first emitters (5) is provided, and the plurality of first emitters (5) is located in the first backlight portion (32).

10. The display screen assembly (10) according to claim 8, wherein the backlight assembly (3) comprises a first backlight portion (32) and a second backlight portion (33) that are connected to each other, the first backlight portion (32) directly faces a region where the plurality of image sensors (21) is located, the second backlight portion (33) directly faces a region where the plurality of thin film transistors (22) is located, and the first emitter (5) is located at a position of the second backlight portion (33) close to the first backlight portion (32).

11. The display screen assembly (10) according to claim 10, wherein the backlight assembly (3) further comprises a plurality of second emitters (34) arranged in an array, the plurality of second emitters (34) is configured to emit visible light towards the second display laminate (1), the plurality of second emitters (34) is located on the second backlight portion (33), and a plurality of first emitters (5) is provided, each of the plurality of first emitters (5) being arranged between two adjacent second emitters of the plurality of second emitters (34).

12. An electronic device (100), comprising the display screen assembly (10) according to any one of claims 1 to 10.

## Patentansprüche

1. Anzeigebildschirmanordnung (10), umfassend:
ein erstes Anzeigelaminat (2) und ein zweites Anzeigelaminat (1), die einander gegenüberliegen;
eine Vielzahl von Bildsensoren (21), angeordnet auf dem ersten Anzeigelaminat (2); und
ein Kameraobjektiv (11), angeordnet auf dem zweiten Anzeigelaminat (1),
wobei die Vielzahl von Bildsensoren (21) direkt dem Kameraobjektiv (11) zugewandt ist und die Vielzahl von Bildsensoren (21) dazu konfiguriert ist, Bildsignale durch das Kameraobjektiv (11) zu erfassen,
**dadurch gekennzeichnet, dass**
das zweite Anzeigelaminat (1) eine Vielzahl von Farbfiltern (12) neben dem Kameraobjektiv (11), einen ersten Lichtabschirmungsblock (13) und eine Vielzahl zweiter Lichtabschirmungsblöcke (14) umfasst, die voneinander beabstandet sind; die Vielzahl von Farbfiltern (12) einer Vielzahl von Subpixelbereichen (16) in einer Eins-zu-eins-Entsprechung entspricht; jeder der Vielzahl zweiter Lichtabschirmungsblöcke (14) sich zwischen zwei benachbarten Farbfiltern (12) der Vielzahl von Farbfiltern (12) befindet und der erste Lichtabschirmungsblock (13) und die Vielzahl zweiter Lichtabschirmungsblöcke (14) dazu konfiguriert sind, sichtbares Licht abzuschirmen,
der erste Lichtabschirmungsblock (13) einen Erweiterungsabschnitt (131) in zylindrischer Form umfasst, wobei sich der Erweiterungsabschnitt (131) von dem zweiten Anzeigelaminat (1) zu dem ersten Anzeigelaminat (2) erstreckt, ein Ende des Erweiterungsabschnitts (131) die Umfangsseite des Kameraobjektivs (11) umgibt und das andere Ende des Erweiterungsabschnitts (131) eine Umfangsseite der Vielzahl von Bildsensoren (21) umgibt.

2. Anzeigebildschirmanordnung (10) nach Anspruch 1, wobei das erste Anzeigelaminat (2) eine Vielzahl von Abtastleitungen (161), eine Vielzahl von Datenleitungen (162) und eine Vielzahl von Dünnschichttransistoren (22) umfasst;
die Vielzahl von Abtastleitungen (161) die Vielzahl von Datenleitungen (162) schneidet, um die Vielzahl von in einem Array angeordneten Subpixelbereiche (16) zu definieren;
mindestens einer der Vielzahl von Dünnschichttransistoren (22) in einem der Vielzahl von Subpixelbereichen (16) angeordnet ist; und
die Vielzahl von Bildsensoren (21) sich außerhalb der Vielzahl von Subpixelbereichen (16) und benachbart zu der Vielzahl von Subpixelbereichen (16) befindet oder die Vielzahl von Bildsensoren (21) in der Vielzahl von Subpixelbereichen (16) angeordnet ist.

3. Anzeigebildschirmanordnung (10) nach Anspruch 1, wobei das zweite Anzeigelaminat (1) ferner ein Substrat (111), eine auf dem Substrat (111) angeordnete organische lichtemittierende Schicht (112) und eine Einkapselungsschicht (113), die die organische lichtemittierende Schicht (112) bedeckt, umfasst, wobei das Kameraobjektiv (11) in der Einkapselungsschicht (113) eingebettet ist.

4. Anzeigebildschirmanordnung (10) nach Anspruch 3, wobei die Einkapselungsschicht (113) einen Abdeckabschnitt (114) und einen Randabschnitt (115) umfasst, der den Abdeckabschnitt (114) umgibt, wobei der Abdeckabschnitt (114) dazu konfiguriert ist, die organische lichtemittierende Schicht (112) abzudecken, der Randabschnitt (115) dazu konfiguriert ist, einen Randbereich der organischen lichtemittierenden Schicht (112) abzudecken, und das Kameraobjektiv (11) in dem Randabschnitt (115) eingebettet ist.

5. Anzeigebildschirmanordnung (10) nach einem der Ansprüche 1 bis 4, ferner umfassend einen ersten Emitter (5) und einen Empfänger (6),
wobei sich der Empfänger (6) auf dem ersten Anzeigelaminat (2) befindet und der Empfänger (6) dazu konfiguriert ist, unsichtbares Licht zu empfangen, das von dem ersten Emitter (5) emittiert und von einem zu erkennenden Objekt reflektiert wird, oder der Empfänger (6) dazu konfiguriert ist, die Helligkeit des Umgebungslichts zu erkennen, und
wobei der erste Emitter (5) sich auf dem zweiten Anzeigelaminat (1) befindet; oder der erste Emitter (5) sich auf dem ersten Anzeigelaminat (2) befindet; oder der erste Emitter (5) sich in einem Bereich außerhalb des zweiten Anzeigelaminats (1) und des ersten Anzeigelaminats (2) befindet.

6. Anzeigebildschirmanordnung (10) nach Anspruch 5, wobei eine Vielzahl von Empfängern (6) bereitgestellt ist und die Vielzahl von Empfängern (6) direkt einem Bereich des zweiten Anzeigelaminats (1) zugewandt ist, in dem das Kameraobjektiv (11) angeordnet ist, und
wobei die Vielzahl von Bildsensoren (21) in einem Array angeordnet ist und jeder der Vielzahl von Empfängern (6) zwischen zwei benachbarten Bildsensoren (21) der Vielzahl von Bildsensoren (21) angeordnet ist.

7. Anzeigebildschirmanordnung (10) nach Anspruch 5, wobei eine Vielzahl von Empfängern (6) bereitgestellt ist, wobei einer oder mehrere Empfänger der Vielzahl von Empfängern (6) sich in einem Subpixelbereich der Vielzahl von Subpixelbereichen (16) befinden und der eine oder die mehreren Empfänger (6) und der mindestens eine der Vielzahl von Dünnschichttransistoren (22), die sich in dem einen Subpixelbereich (16) befinden, benachbart zueinander oder in einer Diagonale angeordnet sind.

8. Anzeigebildschirmanordnung (10) nach Anspruch 7, ferner umfassend eine Hintergrundbeleuchtungsanordnung (3), wobei die Hintergrundbeleuchtungsanordnung (3) einer Seite des ersten Anzeigelaminats (2) zugewandt ist, die dem zweiten Anzeigelaminat (1) abgewandt ist, wobei der erste Emitter (5) sich auf der Hintergrundbeleuchtungsanordnung (3) befindet und der erste Emitter (5) dazu konfiguriert ist, das unsichtbare Licht in Richtung des ersten Anzeigelaminats (2) zu emittieren.

9. Anzeigebildschirmanordnung (10) nach Anspruch 8, wobei die Hintergrundbeleuchtungsanordnung (3) einen ersten Hintergrundbeleuchtungsabschnitt (32) und einen zweiten Hintergrundbeleuchtungsabschnitt (33) umfasst, die direkt miteinander verbunden sind, wobei der erste Hintergrundbeleuchtungsabschnitt (32) direkt einem Bereich zugewandt ist, in dem sich die Vielzahl von Bildsensoren (21) befindet, der zweite Hintergrundbeleuchtungsabschnitt (33) direkt einem Bereich zugewandt ist, in dem sich die Vielzahl von Dünnschichttransistoren (22) befindet, eine Vielzahl erster Emitter (5) bereitgestellt ist, und die Vielzahl erster Emitter (5) sich in dem ersten Hintergrundbeleuchtungsabschnitt (32) befindet.

10. Anzeigebildschirmanordnung (10) nach Anspruch 8, wobei die Hintergrundbeleuchtungsanordnung (3) einen ersten Hintergrundbeleuchtungsabschnitt (32) und einen zweiten Hintergrundbeleuchtungsabschnitt (33) umfasst, die direkt miteinander verbunden sind, wobei der erste Hintergrundbeleuchtungsabschnitt (32) direkt einem Bereich zugewandt ist, in dem sich die Vielzahl von Bildsensoren (21) befindet, der zweite Hintergrundbeleuchtungsabschnitt (33) direkt einem Bereich zugewandt ist, in dem sich die Vielzahl von Dünnschichttransistoren (22) befindet, und der erste Emitter (5) sich an einer Position des zweiten Hintergrundbeleuchtungsabschnitts (33) in der Nähe des ersten Hintergrundbeleuchtungsabschnitts (32) befindet.

11. Anzeigebildschirmanordnung (10) nach Anspruch 10, wobei die Hintergrundbeleuchtungsanordnung (3) ferner eine Vielzahl zweiter Emitter (34) umfasst, angeordnet in einem Array, wobei die Vielzahl zweiter Emitter (34) dazu konfiguriert ist, sichtbares Licht in Richtung des zweiten Anzeigelaminats (1) zu emittieren, die Vielzahl zweiter Emitter (34) auf dem zweiten Hintergrundbeleuchtungsabschnitt (33) befindet eine Vielzahl erster Emitter (5) bereitgestellt ist, wobei jeder der Vielzahl erster Emitter (5) angeordnet ist zwischen zwei benachbarten zweiten Emittern der Vielzahl zweiter Emitter (34).

12. Elektronische Vorrichtung (100), umfassend die Anzeigebildschirmanordnung (10) nach einem der Ansprüche 1 bis 10.

## Revendications

1. Ensemble écran d'affichage (10), comprenant :
un premier stratifié d'affichage (2) et un deuxième stratifié d'affichage (1) qui sont en face l'un de l'autre ;
une pluralité de capteurs d'image (21) disposés sur le premier stratifié d'affichage (2) ; et
un objectif de caméra (11) disposé sur le deuxième stratifié d'affichage (1),
dans lequel la pluralité de capteurs d'image (21) fait directement face à l'objectif de caméra (11), et la pluralité de capteurs d'image (21) est configurée pour acquérir des signaux d'image par le biais de l'objectif de caméra (11),
**caractérisé en ce que**
le deuxième stratifié d'affichage (1) comprend une pluralité de filtres colorés (12) adjacents à l'objectif de caméra (11), un premier bloc faisant écran à la lumière (13) et une pluralité de deuxièmes blocs faisant écran à la lumière (14) qui sont espacés les uns des autres, la pluralité de filtres colorés (12) correspond à une pluralité de sous-régions de pixels (16) dans une correspondance biunivoque ; chacun de la pluralité de deuxièmes blocs faisant écran à la lumière (14) est situé entre deux filtres colorés (12) adjacents de la pluralité de filtres colorés (12), et le premier bloc faisant écran à la lumière (13) et la pluralité de deuxièmes blocs faisant écran à la lumière (14) sont configurés pour faire écran à la lumière visible,
le premier bloc faisant écran à la lumière (13) comprend une partie d'extension (131) dans une forme cylindrique, la partie d'extension (131) s'étend depuis le deuxième stratifié d'affichage (1) jusqu'au premier stratifié d'affichage (2), une extrémité de la partie d'extension (131) entoure le côté périphérique de l'objectif de caméra (11), et l'autre extrémité de la partie d'extension (131) entoure un côté périphérique de la pluralité de capteurs d'image (21).

2. Ensemble écran d'affichage (10) selon la revendication 1, dans lequel le premier stratifié d'affichage (2) comprend une pluralité de lignes de balayage (161), une pluralité de lignes de données (162), et une pluralité de transistors en couches minces (22) ;
la pluralité de lignes de balayage (161) croise la pluralité de lignes de données (162) pour définir la pluralité de sous-régions de pixels (16) disposées en une matrice ;
au moins un de la pluralité de transistors en couches minces (22) est disposé dans une de la pluralité de sous-régions de pixels (16) ; et
la pluralité de capteurs d'image (21) est située à l'extérieur de la pluralité de sous-régions de pixels (16) et adjacente à la pluralité de sous-régions de pixels (16), ou bien la pluralité de capteurs d'image (21) est disposée dans la pluralité de sous-régions de pixels (16).

3. Ensemble écran d'affichage (10) selon la revendication 1, dans lequel le deuxième stratifié d'affichage (1) comprend en outre un substrat (111), une couche électroluminescente organique (112) disposée sur le substrat (111), et une couche d'encapsulation (113) recouvrant la couche électroluminescente organique (112), l'objectif de caméra (11) étant incorporé dans la couche d'encapsulation (113).

4. Ensemble écran d'affichage (10) selon la revendication 3, dans lequel la couche d'encapsulation (113) comprend une partie de recouvrement (114), et une partie de bord (115) entourant la partie de recouvrement (114), la partie de recouvrement (114) est configurée pour recouvrir la couche électroluminescente organique (112), la partie de bord (115) est configurée pour recouvrir une région périphérique de la couche électroluminescente organique (112), et l'objectif de caméra (11) est incorporé dans la partie de bord (115).

5. Ensemble écran d'affichage (10) selon l'une quelconque des revendications 1 à 4, comprenant en outre un premier émetteur (5) et un récepteur (6),
dans lequel le récepteur (6) est situé sur le premier stratifié d'affichage (2), et le récepteur (6) est configuré pour recevoir de la lumière invisible émise par le premier émetteur (5) et réfléchie par un objet devant être détecté, ou bien le récepteur (6) est configuré pour détecter la luminosité de la lumière ambiante, et
dans lequel le premier émetteur (5) est situé sur le deuxième stratifié d'affichage (1) ; ou bien le premier émetteur (5) est situé sur le premier stratifié d'affichage (2) ; ou bien le premier émetteur (5) est situé dans une région à l'extérieur du deuxième stratifié d'affichage (1) et du premier stratifié d'affichage (2).

6. Ensemble écran d'affichage (10) selon la revendication 5, dans lequel une pluralité de récepteurs (6) est prévue, et la pluralité de récepteurs (6) fait directement face à une région du deuxième stratifié d'affichage (1) où l'objectif de caméra (11) est disposé, et
dans lequel la pluralité de capteurs d'image (21) est disposée en une matrice, et chacun de la pluralité de récepteurs (6) est disposé entre deux capteurs d'image (21) adjacents de la pluralité de capteurs d'image (21).

7. Ensemble écran d'affichage (10) selon la revendication 5, dans lequel une pluralité de récepteurs (6) est prévue, un ou plusieurs récepteurs de la pluralité de récepteurs (6) sont situés dans une sous-région de pixels de la pluralité de sous-régions de pixels (16), et le ou les récepteurs (6) et l'au moins un de la pluralité de transistors en couches minces (22) situé dans la sous-région de pixels (16) sont adjacents l'un à l'autre ou disposés en diagonale.

8. Ensemble écran d'affichage (10) selon la revendication 7, comprenant en outre un ensemble de rétroéclairage (3), dans lequel l'ensemble de rétroéclairage (3) fait face à un côté du premier stratifié d'affichage (2) tournant le dos au deuxième stratifié d'affichage (1), le premier émetteur (5) est situé sur l'ensemble de rétroéclairage (3), et le premier émetteur (5) est configuré pour émettre la lumière invisible vers le premier stratifié d'affichage (2) .

9. Ensemble écran d'affichage (10) selon la revendication 8, dans lequel l'ensemble de rétroéclairage (3) comprend une première partie de rétroéclairage (32) et une deuxième partie de rétroéclairage (33) qui sont reliées l'une à l'autre, la première partie de rétroéclairage (32) fait directement face à une région où la pluralité de capteurs d'image (21) est située, la deuxième partie de rétroéclairage (33) fait directement face à une région où la pluralité de transistors en couches minces (22) est située, une pluralité de premiers émetteurs (5) est prévue, et la pluralité de premiers émetteurs (5) est située dans la première partie de rétroéclairage (32).

10. Ensemble écran d'affichage (10) selon la revendication 8, dans lequel l'ensemble de rétroéclairage (3) comprend une première partie de rétroéclairage (32) et une deuxième partie de rétroéclairage (33) qui sont reliées l'une à l'autre, la première partie de rétroéclairage (32) fait directement face à une région où la pluralité de capteurs d'image (21) est située, la deuxième partie de rétroéclairage (33) fait directement face à une région où la pluralité de transistors en couches minces (22) est située, et le premier émetteur (5) est situé à une position de la deuxième partie de rétroéclairage (33) proche de la première partie de rétroéclairage (32).

11. Ensemble écran d'affichage (10) selon la revendication 10, dans lequel l'ensemble de rétroéclairage (3) comprend en outre une pluralité de deuxièmes émetteurs (34) disposés en une matrice, la pluralité de deuxièmes émetteurs (34) est configurée pour émettre de la lumière visible vers le deuxième stratifié d'affichage (1), la pluralité de deuxièmes émetteurs (34) est située sur la deuxième partie de rétroéclairage (33), et une pluralité de premiers émetteurs (5) est prévue, chacun de la pluralité de premiers émetteurs (5) étant disposé entre deux deuxièmes émetteurs adjacents de la pluralité de deuxièmes émetteurs (34).

12. Dispositif électronique (100), comprenant l'ensemble écran d'affichage (10) selon l'une quelconque des revendications 1 à 10.
